Europäisches Patentamt

European Patent Office

Office européen des brevets

(19)

(11) Numéro de publication: **0 135 230**
**B1**

(12) **FASCICULE DE BREVET EUROPEEN**

(45) Date de publication du fascicule du brevet:
**19.11.87**

(21) Numéro de dépôt: **84201177.7**

(22) Date de dépôt: **15.08.84**

(51) Int. Cl.⁴: **H 01 L 23/56, H 01 L 23/48**

(54) **Dispositif semi-conducteur, notamment transistor incluant des moyens de protection contre les surcharges.**

(30) Priorité: **17.08.83 FR 8313372**

(43) Date de publication de la demande:
**27.03.85 Bulletin 85/13**

(45) Mention de la délivrance du brevet:
**19.11.87 Bulletin 87/47**

(84) Etats contractants désignés:
**DE FR GB NL**

(56) Documents cités:
**US - A - 3 461 462**

**PATENTS ABSTRACTS OF JAPAN, vol. 6, no.
247(E-146)(1125), 7 décembre 1982**

(73) Titulaire: **RTC-COMPELEC, 130, Avenue Ledru-Rollin,
F-75011 Paris (FR)**
(84) Etats contractants désignés: **FR**

(73) Titulaire: **N.V. Philips' Gloeilampenfabrieken,
Groenewoudseweg 1, NL-5621 BA Eindhoven (NL)**
(84) Etats contractants désignés: **DE GB NL**

(72) Inventeur: **Roger, Bernard, Societe Civile S.P.I.D. 209 rue
de l'Université, F-75007 Paris (FR)**

(74) Mandataire: **Pinchon, Pierre et ai, Société Civile
S.P.I.D. 209 rue de l'Université, F-75007 Paris (FR)**

## Description

La présente invention concerne un dispositif semi-conducteur, notamment un transistor, en particulier un transistor de puissance, comprenant un corps semi-conducteur fixé par soudure sur un support, et comportant en surface des plages métalliques de prise de contact incluant des moyens de protection contre les surcharges.

Un dispositif semi-conducteur comprenant un corps semi-conducteur fixé par un alliage en aluminium-germanium sur un support est connu du document US-A-3461462.

On connaît les problèmes posés par le manque de dissipation thermique dans les transistors enrobés dans une matière peu conductrice de la chaleur, notamment dans une enveloppe en matière plastique. Ce phénomène est particulièrement sensible dans le cas des transistors de puissance pour lesquels l'effet d'une surcharge en courant, en tension ou en énergie se traduit généralement par la destruction des deux jonctions qui forment alors un court-circuit.

Si le transistor incriminé est utilisé dans un dispositif de régulation (régulation de vitesse d'un moteur, régulation de tension d'un alternateur, circuit antiblocage de freins par exemple), le fait de créer un court-circuit laisse la commande de régulation bloquée dans sa position maximale, ce qui peut devenir catastrophique.

L'expérience a montré que le court-circuit se produit sur le transistor lorsque, pendant une surcharge quelconque, une zone de faible surface du cristal semi-conducteur, généralement en silicium, est portée à une température telle qu'il y a formation d'un eutectique entre le matériau semi-conducteur et la couche métallisée de prise de contact déposée en surface. Ce phénomène est d'autant plus rapide et fréquent que le flot de chaleur s'écoule lentement, ce qui est le cas en particulier dans les dispositifs enrobés dans une matière plastique.

L'expérience a montré également que la température qui conduit à cette formation localisée d'un eutectique du cristal semi-conducteur et de la couche métallisée, avoisine 560 °C, dans le cas d'une couche métallisée en aluminium et d'un contact en silicium.

On connaît déjà des dispositifs semi-conducteurs à circuits intégrés, notamment des mémoires programmables, dans lesquels sont réalisés des fusibles. Cependant, pour ce qui concerne ces dispositifs les moyens mis en œuvre ne concernent pas pour résoudre le problème posé par cette formation indésirable d'un eutectique.

Ainsi, dans le cas des mémoires programmables de circuits intégrés, les éléments fusibles doivent être détruits volontairement et sélectivement pour des valeurs de courant ou d'énergie prédéterminées et relativement importantes qui conduisent à utiliser notamment des matériaux particulièrement résistifs, fondant à des températures très élevées et, en général, largement supérieures à 1000°C.

A contrario, l'idée de base de la présente invention consiste à réaliser, en un endroit approprié, un élément fusible dont le point de fusion est adapté à celui de la formation de l'eutectique.

La présente invention concerne ainsi un dispositif semi-conducteur, en particulier un transistor de puissance, du type précité dans lequel au moins une desdites plages métalliques comporte un matériau susceptible de former un eutectique avec le substrat, ladite plage métallique étant réalisée en un alliage dudit matériau ayant un point de fusion dont la température est inférieure à la température de formation dudit eutectique et supérieure à la température de soudage du corps semi-conducteur sur son support.

Le but de la présente invention est donc d'utiliser un type de couche de métallisation fondant à une température inférieure à 560 °C, température de formation de l'eutectique Al-Si, dans le cas d'une couche de contact en aluminium sur un substrat en silicium, tout en permettant, d'une part, un montage satisfaisant du cristal ou corps semi-conducteur sur son support et, d'autre part, le soudage des fils de connexion sur les plages de prises de contact, étant entendu que ces dernières doivent rester parfaitement conductrices de l'électricité.

Selon un mode de réalisation préféré, on choisit, une couche de l'eutectique aluminium-germanium dans laquelle on peut adjoindre éventuellement du magnésium et de l'antimoine pour adapter ses caractéristiques.

L'eutectique Al-Ge a un point de fusion de l'ordre de 420 °C, suffisamment élevé pour permettre le soudage du corps semi-conducteur, le plus souvent du silicium, sur son support mais suffisamment bas pour que, en un point d'une plage de prise de contact réalisée dans cette couche, la métallisation fonde de manière à provoquer l'ouverture du circuit, avant que ne se produise un court-circuit au sein du corps semi-conducteur.

La destruction du transistor par apparition d'un circuit ouvert au lieu d'un court-circuit permet de supprimer les risques d'emballement des phénomènes électriques et permet donc également de protéger les éléments voisins du transistor.

Si nécessaire, la couche métallique servant à l'obtention des plages de prise de contact est recouverte d'une couche d'aluminium pur de faible épaisseur par rapport à ladite couche métallique pour garantir une meilleure fiabilité des contacts et des soudures des fils et pour améliorer les conductions électriques et/ou thermiques. De même une sous-couche en aluminium pur également de faible épaisseur disposée en dessous de la couche métallique autorise une meilleure adhérence sur le substrat.

L'invention sera mieux comprise à la lecture de la description qui va suivre, donnée à titre d'exemple non limitatif, en liaison avec les figures qui représentent:

Les fig. 1a et 2, un détail du dispositif de l'invention montrant une plage métallique respectivement avant et après fusion, et la fig. 1b une variante de la fig. 1a;

la fig. 3, un transistor suivant l'invention.

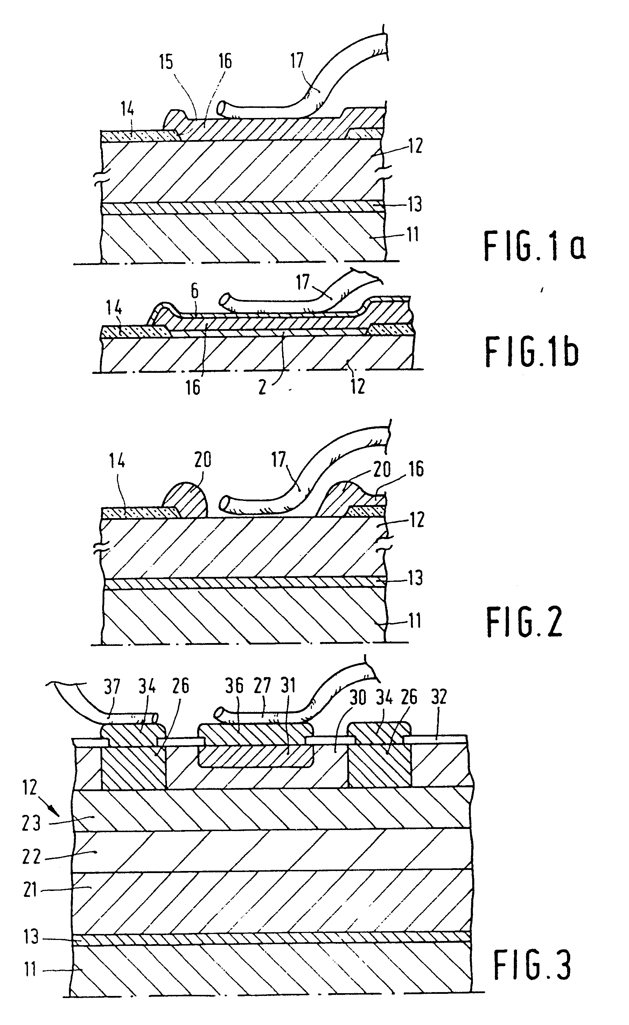

Selon la fig. 1a, un corps semi-conducteur 12 est soudé sur un support 11 par l'intermédiaire d'une couche 13.

A titre d'exemple, le support 11 est en cuivre recouvert de nickel. Avant soudure, la face inférieure du corps 12 en silicium est revêtue d'une couche d'or, la couche 13 étant obtenue par formation d'un eutectique Au-Si lorsqu'on applique le corps 12 sur le support 11 à une température voisine de 400 °C. On sait en effet que l'eutectique Au-Si se forme à 370 °C.

A la fig. 1a, on a également représenté une fenêtre 15 ménagée dans une couche l'oxyde 14 déposée à la surface supérieure du corps semi-conducteur 12. Dans celle-ci est déposée une couche métallique 16 sur laquelle est soudé un fil de connexion 17.

Dans le cas où la couche métallique 16 est en aluminium et le corps semi-conducteur 12 en silicium, un eutectique Al-Si est susceptible de se former si la température atteint ou dépasse localement 560 °C. L'aluminium de la couche 16 diffuse dans le silicium du corps 12 et produit un court-circuit.

Selon l'invention, la couche métallique 16 contient toujours de l'aluminium, mais elle est réalisée de telle manière que sa fusion se produise à une température inférieure à 560 °C.

On constate alors de manière surprenante qu'en cas d'échauffement (voir fig. 2), la couche 16 à l'état liquide se trouve expulsée de la zone où elle est en contact avec le fil de connexion 17 et vient se solidifier tout autour de celui-ci en formant un anneau 20. Le fil de connexion 17 se trouve alors espacé d'une certaine distance de la surface du corps 12 et le transistor est détruit par interruption du passage du courant et non plus par court-circuit.

On réalisera de préférence la couche 16 en eutectique Al-Ge qui présente une composition de 55% du poids en Ge et dont la température de fusion est de 423 °C, donc assez largement inférieure à la température de formation de l'eutectique Al-Si (560 °C).

Cette température est toutefois supérieure à celle (370 °C) aux alentours de laquelle on peut réaliser ultérieurement la soudure du corps 12 sur le support 11 par formation d'un eutectique Au-Si.

La couche 16 en Al-Ge, d'une épaisseur de 3 à 6 microns environ peut être déposée par évaporation dans une chambre à vide présentant deux sources séparées, une de Ge et une de Al, chacune étant chauffée par un canon à électrons. Le courant dans chaque canon à électrons permet de régler le taux d'évaporation. Par conséquent, on obtient la stoechiométrie de l'eutectique en faisant fonctionner les deux canons à électrons avec des taux d'évaporation appropriés. Pendant l'évaporation, le substrat 12 est maintenu à une température comprise entre 150 et 300 °C, et de préférence à 250 °C.

Une sous-couche 2 en aluminium pur, d'une épaisseur de 5–10 nm (50 à 100 Å) environ peut également être déposée par évaporation de manière à augmenter l'adhérence de la couche 16 au substrat 12 en silicium et à améliorer la qualité électrique du contact. Son épaisseur est faible par rapport à celle de la couche 16 de manière à ne pas induire de modification sensible de la température de fusion de la couche 16.

De plus, on peut avantageusement déposer par évaporation au dessus de la couche 16, une couche 6 en aluminium pur de 2 à 10 nm (20 à 100 Å) d'épaisseur environ, de manière à éviter l'oxydation du germanium de la couche 16 lors du stockage du substrat, et à faciliter une photogravure éventuelle de la couche 16 grâce à une meilleure adhérence de la laque.

La couche 6 a une épaisseur faible par rapport à celle de la couche 16 pour la même raison que précédemment.

D'autres matériaux peuvent être utilisés pour réaliser la couche 16, par exemple l'eutectique Al-Zn, lequel présente une proportion pondérale de zinc de 95% et une température de fusion de 382 °C, ou bien l'eutectique Al-Mg, lequel présente une proportion pondérale de 67,8% de magnésium et une température de fusion de 437 °C.

On peut également mettre en œuvre des compositions ternaires par addition d'une proportion donnée de Zn ou de Mg dans l'alliage Al-Ge, ce qui produit des eutectiques ayant également des températures de fusion adaptées.

Selon la fig. 3, le substrat 12 présente une couche 22 de type N formant le collecteur d'un transistor, une région 23 de type p formant une région de base, et une région 24 de type n formant une région d'émetteur.

Un puits de contour parallélépipédique ou annulaire 26, fortement dopé $p^+$ entoure la région d'émetteur 24 de manière à venir former une région de contact de base entre une métallisation 34 sur laquelle est soudé un fil de contact de base 37 et la région de base 23.

La région d'émetteur 30 présente une zone centrale 31 fortement dopée $n^+$ sur laquelle est déposée une métallisation 36, sur laquelle est soudée un fil de contact d'émetteur 27.

L'une ou l'autre des métallisations 36, si elle contient un corps tel que Al susceptible de former un eutectique avec les substrat 12 par exemple en Si, est conformément à l'invention, réalisée de manière à présenter un point de fusion de température inférieure à la température de formation dudit eutectique et supérieure à la température de soudage du substrat semi-conducteur (12) sur son support (11).

## Revendications

1. Dispositif semi-conducteur, en particulier transistor présentant un support (11) sur lequel est soudé un corps semi-conducteur (12) comportant une surface sur laquelle sont disposées des plages métalliques de prise de contact (16, 34, 36) incluant des moyens de protection contre les surcharges, caractérisé en ce qu'au moins une desdites plages métalliques (16, 34, 36) comporte un matériau susceptible de former un eutectique avec le substrat et en ce qu'elle est réalisée en un alliage dudit matériau présentant un point de fusion de température inférieure à la température de formation dudit eutectique et supérieur à la température de soudage de corps semi-conducteur (12) sur son support (11).

2. Dispositif selon la revendication 1, caractérisé en ce que ledit alliage est en eutectique aluminium-germanium.

3. Dispositif selon la revendication 2, caractérisé en ce que ledit alliage comporte également au moins un élément du groupe comprenant le magnésium et l'antimoine.

4. Dispositif selon la revendication 1, caractérisé en ce que ledit alliage est l'eutectique aluminium-zinc.

5. Dispositif selon la revendication 1, caractérisé en ce que ledit alliage est l'eutectique aluminium-magnésium.

6. Dispositif selon une des revendications précédentes, caractérisé en ce qu'au moins ladite plage métallique (16) comporte une sous-couche (2) en aluminium d'épaisseur faible par rapport à celle de ladite plage métallique (16).

7. Dispositif selon une des revendications précédentes, caractérisé en ce qu'au moins ladite plage métallique est revêtue d'une couche d'aluminium (3) d'épaisseur faible par rapport à celle de ladite plage métallique (16).

8. Dispositif selon une des revendications précédentes, caractérisé en ce qu'il est du type transistor de puissance.

**Patentansprüche**

1. Halbleiteranordnung, insbesondere Transistor, mit einem Träger (11), auf dem ein Halbleiterkörper (12) festgelötet ist, mit einer Oberfläche, auf der metallische Kontaktgebiete (16, 34, 36) vorgesehen sind, einschliesslich Überlastungsschutzmittel, dadurch gekennzeichnet, dass mindestens eine der genannten metallischen Gebiete (16, 34, 36) ein Material aufweist, das mit dem Substrat ein Eutektikum bilden kann und dass dieses Gebiet aus einer Legierung des genannten Materials mit einem Schmelzpunkt, dessen Temperatur niedriger ist als die Temperatur, bei der das Eutektikum gebildet wird, und höher ist als die Temperatur, bei der der Halbleiterkörper (12) auf dem Träger (11) festgelötet wird, gebildet wird.

2. Anordnung nach Anspruch 1, dadurch gekennzeichnet, dass die genannte Legierung ein Eutektikum Aluminium-Germanium ist.

3. Anordnung nach Anspruch 2, dadurch gekennzeichnet, dass die genannte Legierung auch mindestens ein Element der Gruppe aufweist, die Magnesium und Antimon enthält.

4. Anordnung nach Anspruch 1, dadurch gekennzeichnet, dass die genannte Legierung das Eutektikum Aluminium-Zink ist.

5. Anordnung nach Anspruch 1, dadurch gekennzeichnet, dass die genannte Legierung das Eutektikum Aluminium-Magnesium ist.

6. Anordnung nach einem der vorstehenden Ansprüche, dadurch gekennzeichnet, dass mindestens das genannte metallische Gebiet (16) eine Unterschicht (2) aus Aluminium aufweist mit einer Dicke, die gegenüber der des genannten metallischen Gebietes (16) gering ist.

7. Anordnung nach einem der vorstehenden Ansprüche, dadurch gekennzeichnet, dass mindestens das genannte metallische Gebiet mit einer Aluminiumschicht (3) bedeckt ist, die eine Dicke hat, die gegenüber der des genannten metallischen Gebietes (16) gering ist.

8. Anordnung nach einem der vorstehenden Ansprüche, dadurch gekennzeichnet, dass diese vom Leistungstransistortyp ist.

**Claims**

1. A semiconductor device, more particularly a transistor, having a support (11) on which is soldered a semiconductor body (12) comprising a surface on which metallic connection contact areas (16, 34, 36) are disposed including means for protection against overloads, characterized in that at least one of the said metallic areas (16, 34, 36) comprising a material susceptible to forming a eutectic with the substrate, and in that it is made of an alloy of the said material having a melting point of a temperature lower than the temperature at which the said eutectic is formed and higher than the temperature at which the semiconductor body (12) is soldered on its support (11).

2. A device as claimed in claim 1, characterized in that the said alloy is an eutectic aluminium-germanium.

3. A device as claimed in claim 2, characterized in that the said alloy also comprises at least one element of the group comprising magnesium and antimony.

4. A device as claimed in claim 1, characterized in that the said alloy is an eutectic aluminium-zinc.

5. A device as claimed in claim 1, characterized in that the said alloy is an eutectic aluminium-magnesium.

6. A device as claimed in any one of the preceding claims, characterized in that at least the said metallic area comprises a sub layer (2) of aluminium having a thickness which is small with respect to the said metallic area (6).

7. A device as claimed in any one of the preceding claims, characterized in that at least the said metallic area is coated with an aluminium layer (3) having a thickness which is small with respect to that of the said metallic area (16).

8. A device as claimed in any one of the preceding claims, characterized in that it is a power transistor.

FIG.1a

FIG.1b

FIG.2

FIG.3